(19) Europäisches Patentamt

European Patent Office

Office européen des brevets

(11) **EP 0 546 248 B1**

(12) **EUROPÄISCHE PATENTSCHRIFT**

(45) Veröffentlichungstag und Bekanntmachung des Hinweises auf die Patenterteilung:
**11.09.1996 Patentblatt 1996/37**

(51) Int Cl.[6]: **C23C 14/26**, C23C 14/24

(21) Anmeldenummer: **92111365.0**

(22) Anmeldetag: **03.07.1992**

(54) **Verdampferschiffchen für eine Vorrichtung zur Beschichtung von Substraten**

Evaporator boat for a substrate-coating apparatus

Nacelle d'évaporation pour dispositif de revêtement des substrats

(84) Benannte Vertragsstaaten:
**CH DE FR GB IT LI**

(30) Priorität: **03.12.1991 DE 4139792**

(43) Veröffentlichungstag der Anmeldung:
**16.06.1993 Patentblatt 1993/24**

(73) Patentinhaber: **LEYBOLD AKTIENGESELLSCHAFT D-63450 Hanau (DE)**

(72) Erfinder: **Grimm, Helmut, Dr.
W-6100 Darmstadt 12 (DE)**

(56) Entgegenhaltungen:
DE-C- 975 566        US-A- 3 210 525
US-A- 3 598 958      US-A- 4 089 643

• **PATENT ABSTRACTS OF JAPAN vol. 1, no. 9 (C-002) 17. März 1977 & JP-A-51 119 386 (DENKI KAGAKU KOGYO) 19. Oktober 1976**

**Beschreibung**

Die Erfindung betrifft ein Verdampferschiffchen für eine Vorrichtung zur Beschichtung von Substraten in einer Vakuumbeschichtungskammer, bestehend aus einem flachen, trogförmigen Teil aus einem elektrisch leitenden Werkstoff, wobei das Schiffchen durch direkten Stromdurchgang beheizbar ist.

Es sind Verdampferschiffchen - insbesondere für Reihenverdampfer - bekannt, deren Grundrißflächen Rechtecke sind und die an ihren beiden lotrechten Schmal- bzw. Stirnseiten mit Einspannflächen versehen sind, mit denen sie sich an der Schiffchenhalterung abstützen.

Bei einer älteren Vorrichtung zur laufenden Beschichtung von bandförmigen Substraten (DE-C-4027034) in einer Vakuumbeschichtungskammer mit einer Vielzahl von eine Verdampferbank bildenden, parallel zueinander und längs zur Bandlaufrichtung, in etwa gleichen Abständen zueinander angeordneten Verdampferschiffchen etwa gleicher Größe und Konfiguration, wobei die Verdampferschiffchen sämtlich aus einer elektrisch leitenden Keramik gebildet und durch direkten Stromdurchgang beheizbar sind und die eine Vorrichtung für die kontinuierliche Zuführung von zu verdampfendem Draht zu den Verdampferschiffchen aufweist, sind die einzelnen Verdampferschiffchen jeweils zueinander versetzt angeordnet, wobei alle Verdampferschiffchen gemeinsam eine schmale Beschichtungszone überdecken, die sich quer zur Bandlaufrichtung erstreckt.

Durch die versetzte Anordnung soll die Aufgabe gelöst werden, die gegenseitige Wechselwirkung der Einzelquellen zu verkleinern und dadurch die Schichtgleichmäßigkeit zu verbessern. Die einzelnen Verdampferschiffchen selbst weisen einen rechteckigen Querschnitt auf, wobei die Vertiefungen zur Aufnahme des Schmelzgutes sämtlich eine rechteckige Grundrißfläche haben.

Bei einer anderen, seit langem bekannten Vorrichtung zur laufenden Bedampfung endloser Gebilde (DE-C-970 246) mit mehreren direkt beheizten, in einer Reihe hintereinanderliegenden Verdampfern hat man bereits versucht, einen Nachteil des bekannten Verdampfertyps mit rechteckiger Grundfläche für die Vertiefung zu beseitigen, der sich daraus ergibt, daß das verdampfende Gut als ausgezeichneter Leiter für den elektrischen Strom den Verdampfer zum Teil kurzschließt, so daß nur die zwischen den einzelnen Vertiefungen vorhandenen Teile des Verdampfers als Wärmegenerator dienen, so daß eine ungleichmäßige Beschichtung erfolgt. Gemäß dieser vorveröffentlichten Druckschrift soll dieser Nachteil dadurch beseitigt werden, daß der Verdampfer zwischen den einzelnen Vertiefungen eine Schwächung des Verdampferquerschnitts aufweist, so daß der elektrische Widerstand des Verdampfers etwa konstant und unabhängig von der Füllmenge des Verdampfungsgutes in den Kammern ist.

In einer älteren Patentanmeldung (P 40 16 225.7) ist ein Reihenverdampfer für Vakuumbedampfungsanlagen, insbesondere für Bandbedampfungsanlagen, beschrieben, bestehend aus mehreren, einzeln in der Leistung steuerbaren, durch Stromdurchgang beheizten, an stützenförmig ausgebildeten elektrischen Zuleitungen anliegenden Verdampfern, wobei die stützenförmigen Zuleitungen von einem sich über die gesamte Länge des Reihenverdampfers erstreckenden, elektrisch leitfähigen Tragkörper gehalen sind und die Zuleitungen der einen Polarität elektrisch leitend mit dem Tragkörper verbunden sind, während die Zuleitungen der anderen Polarität isoliert durch den Tragkörper hindurchgeführt und mit isoliert angeordneten Leitungsdrähten verbunden sind, wobei sich die Verdampfer über vorzugsweise als Zylinderabschnitte ausgeformte Lagerelemente an den oberen Enden oder Nasen der Zuleitungen abstützen, wozu die Lagerelemente aus einem stromleitenden Werkstoff, beispielsweise einer Keramik, gebildet sind.

Dieser ältere Reihenverdampfer löst das Problem der paarweisen Einspannung der Verdampfer zwischen den elektrischen Zuleitungen bzw. des guten elektrischen Kontakts während des Verdampfungsprozesses. Aber auch bei dieser paarweisen Anordnung von Verdampfern ist das Problem einer optimal gleichmäßigen Beschichtung noch nicht vollständig gelöst.

Der vorliegenden Erfindung liegt nun die Aufgabe zugrunde, die Nachteile der bekannten Verdampfer bzw. Verdampferanordnungen zu vermeiden und die Verdampfer so auszubilden, daß eine optimale Beschichtung möglich ist.

Erfindungsgemäß wird dies dadurch erreicht, daß das Verdampferschiffchen eine etwa rhombus- oder rhomboidförmige Grundrißfläche aufweist, wobei die Konfiguration der Vertiefung im wesentlichen derjenigen des Schiffchens entspricht und wobei zwei einander diametral gegenüberliegende Ecken des Verdampferschiffchens jeweils mit einer etwa rechteckigen, lotrechten Abflachung versehen sind, die beide zusammen die einander parallelen Einspannflächen des Verdampferschiffchens bilden.

Mit Vorteil ist die insgesamt sechs Ecken aufweisende Grundrißflächen-Konfiguration des Verdampferschiffchens mit einem Breiten/Längenverhältnis von etwa 1 : 4 versehen, wobei sich die größte Breite zur Breite an einer Einspannstelle wie etwa 1 : 1,3 verhält.

In einer bevorzugten Ausführungsform bildet die etwa rhomboidförmige, an zwei diametral gegenüberliegenden Enden abgeplattete Grundrißfläche des Verdampferschiffchens ein Sechseck, bei dem vier paarweise gegenüberliegende Ecken etwa gleichwinklig ausgebildet sind und bei dem das Verhältnis der größten Längenausdehnung der Vertiefung zu ihrer größten Breitenausdehnung geringer bemessen ist als das Verhältnis der größten Länge des ganzen Schiffchens zu seiner größten Breite.

Eine weitere bevorzugte Ausführungsform ist im abhängigen Anspruch 4 offenbart.

Die Erfindung läßt die verschiedensten Ausführungsmöglichkeiten zu; eine davon ist in der Zeichnung näher dargestellt, und zwar zeigen:

Fig.1 ein herkömmliches Schiffchen in der Draufsicht und im Querschnitt und

Fig. 2 ein Schiffchen nach der vorliegenden Erfindung in der Draufsicht und im Querschnitt.

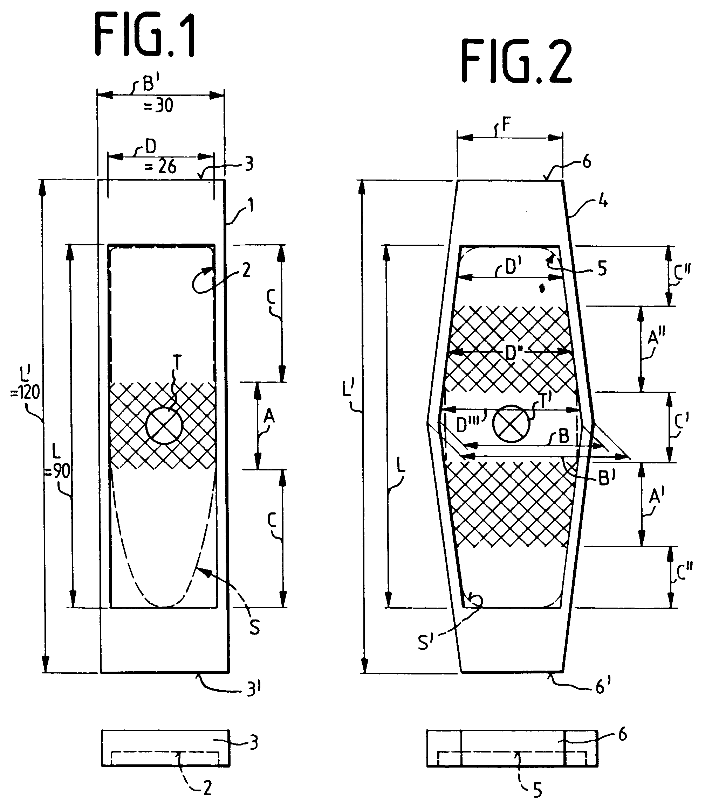

Bei der Kühlung der Einspannbacken der Schiffchenhalterung entsteht ein Temperaturgefälle mit der heißesten Fläche in der Mitte des Schiffchens 1. Über diese Zone A (Fig. 1) von ca. 2 - 3 cm Länge (bei einer Gesamtlänge von 9 cm der Kavität 2) wird erfahrungsgemäß doppelt soviel Aluminium pro Flächeneinheit verdampft wie über dem Rest der Kavitätsfläche.

Um nun eine von Spritzern freie Verdampfung und damit "pinhole"-freie Beschichtung zu erhalten, darf eine vorbestimmte (maximale) Temperatur nicht überschritten werden. Diese wird durch die Temperatur der heißen Zone A definiert. Man erhält damit eine über die gesamte Kavitätsfläche gemittelte Abdampfrate. Gemäß der Erfindung soll der Temperaturgradient verringert werden, so daß eine größere Fläche auf diese (maximale) Temperatur erhöht werden kann, woraus sich eine größere mittlere und von Spritzern freie Abdampfrate ergibt.

Bei der vorgesehenen stirnseitigen Schiffcheneinspannung ist es nun möglich, dieses Ziel ohne großen Aufwand durch eine andere Gestaltung der Schiffchenform zu erreichen (Fig. 2).

Geht man von der Annahme aus, daß über der heißen Zone A bzw. A', A" pro Flächeneinheit doppelt soviel Aluminium abgedampft wird wie über die restliche Fläche, dann ergibt sich die folgende Beziehung:

$\dot{q}_{norm}$ = Abdampfrate in den kälteren Randzonen

$\dot{q}_{heiß}$ = Abdampfrate in der heißen Zone [ g : (min x cm$^2$)]

$\dot{q}_{heiß}$ = 2 x $q_{norm}$

so erhält man als mittlere Abdampfmenge $q_{Stand}$ [g : min] bei einem Standardverdampfer (Fig. 1)

$$\rightarrow \bar{q}_{Standard} = [2 \times C \times q_{norm} + A \times q_{heiß}] \times D$$

$$= [2 \times 3,5 \, q_{norm} + 2 \times q_{heiß}] \times 2,6$$

$$= [7 \times q_{norm} + 2 \, q_{heiß}] \times 2,6$$

$$= [7 \times q_{norm} + 4 \times q_{norm}] \times 2,6$$

$$= 28,6 \times q_{norm}$$

mit

$$L_{ges} = 2 \times C + A = 7,0 \, cm + 2,0 \, cm = 9,0 \, cm$$

und für einen rautenförmigen Verdampfer (Fig. 2)

$$\bar{q}_{Raute} = [2 \times (C'' \times D') \times \dot{q}_{norm} + (C' \times D''') \times \dot{q}_{norm}]$$

$$+ [(A' \times D'') \times \dot{q}_{heiß} + (A'' \times D'') \times \dot{q}_{heiß}]$$

$$= [2 \times 1,5 \times 2,5 \times \dot{q}_{norm} + 2,0 \times 3,4 \times \dot{q}_{norm}]$$

$$+ [(2,0 \times 3,4) \times \dot{q}_{heiß} + (2,0 \times 3,4) \times \dot{q}_{heiß}]$$

$$= [7,5 \times q_{norm} + 6,8 \times q_{norm}] + [13,6 \times q_{heiß}]$$

$$= 14,3 \, q_{norm} + 27,2 \times q_{norm} = 41,5 \times q_{norm}$$

mit

$$L_{ges} = 2 \times C'' + A' + A'' + C' = 2 \times 1,5 \, cm + 2,0 \, cm$$

$$+ 2{,}0\ cm + 2{,}0\ cm = 9{,}0\ cm$$

Dies entspräche einer Erhöhung der mittleren Aufdampfrate um ca. 45 %. Geht man von der Annahme aus, daß in den beiden heißen Zonen A', A' bei der Ausführung gemäß Fig. 2 nicht doppelt soviel, sondern nur das 1,5fache abgedampft wird, so verbleibt immer noch eine Steigerung der mittleren Abdampfrate um ca. 21 %. Es ergeben sich danach folgende Vorteile:

1. Vorteil:     größere mittlere Abdampfrate von 41,5 $\dot{q}_{norm}$ zu 28,6 $\dot{q}_{norm}$

2. Vorteil:     durch geringere Stirnfläche 6 und 6' weniger Wärmeableitung durch diese Flächen

3. Vorteil:     an den Stirnflächen 6 und 6' kleiner Flächenquerschnitt = hoher Flächenwiderstand = große Heizleistung
in der Mitte größerer Flächenquerschnitt = geringerer Flächenwiderstand = kleine Heizleistung

Daraus folgt:     Kompensation des noch vorhandenen Temperaturprofils
Gleichförmigere Benetzung über die gesamte Fläche der Kavität
--> Homogenität der Beschichtung!
--> Längere Standzeit der Verdampfer!

Während ein Standardschiffchen (Fig. 1) beim Aufheizen zuerst in der Mitte (Zone A) des Schiffchens hell glüht und beim Abkühlen zuletzt dort kalt wird, treten beim rautenförmigen Schiffchen (Fig. 2) zwei dieser Zonen A', A'' auf, die außerhalb der Mitte liegen, in der sich die Auftrefffläche T' für den zugeführten Aluminiumdraht befindet.

| Zu Figur 1 | Zu Figur 2 |
|---|---|
| Schiffchen nach dem Stand der Technik (Standard) Fläche der Kavität (Vertiefung) = $A^{St}$ = 2,6 cm x 9,0 cm     = 23,4 cm$^2$ | Schiffchen nach der vorliegenden Erfindung (Rautenform) $A^{Raut}$ = 2,4 + 3,5 : 2     x 9,0 cm     = 26,6 cm$^2$ |
| davon benetzt: ~ 80 % wirksame Abdampffläche: $A^{St}$ ~ 18,7 cm$^2$ | benetzt: ~ 90 % wirksame Abdampffläche: $A^{Raut}$ ~ 23,9 cm$^2$ (d.h. ~ 27,6 % größer) |
| Kühlfläche: $A^{St}$ = 3,0 cm x 1,0 cm     = 3 cm$^2$ | Kühlfläche: $A^{Raut}$ = 2,5 cm x 1,0 cm     = 2,5 cm$^2$ (d.h. ~ 16,7 % geringer) |

**Bezugszeichenliste**

1      Verdampferschiffchen (alt)
2      rechteckige Vertiefung (Kavität)
3, 3'   Kühlfläche = Einspannfläche
4      Verdampferschiffchen (neu)
5      Vertiefung (sechseckig)
6, 6'   Kühlfläche = Einspannfläche

A, A', A''     heiße Zone
B'         größte Breite des Schiffchens
B         größte Breite der Vertiefung
F         Breite der Einspannfläche
L'        größte Länge des Schiffchens
L         größte Länge der Vertiefung
S, S'     benetzte Fläche, gesamt
T, T'     Berührungsort: Draht/Schiffchen

C, C'; C"       benetzte Fläche
D               mittlere Breite der Vertiefung
D'              mittlere Breite der Vertiefung im Abschnitt C"
D"              mittlere Breite der Vertiefung im Abschnitt A"
D'''            mittlere Breite der Vertiefung der jeweils einen Hälfte der Fläche C'

**Patentansprüche**

1.  Verdampferschiffchen (4) für eine Vorrichtung zur Beschichtung von Substraten in einer Vakuumbeschichtungskammer, bestehend aus einem flachen, trogförmigen Teil aus einem elektrisch leitenden Werkstoff, wobei das Schiffchen durch direkten Stromdurchgang beheizbar ist, **dadurch gekennzeichnet** daß das Verdampferschiffchen (4) eine im wesentlichen rhombus- oder rhomboidförmige Grundrißfläche aufweist, wobei die Konfiguration der Vertiefung (5) in etwa derjenigen des Schiffchens (4) entspricht und wobei zwei einander diametral gegenüberliegende Ecken des Verdampferschiffchens jeweils mit einer etwa rechteckigen, lotrechten Abplattung versehen sind, die zusammen die einander parallelen Einspannflächen (6, 6') des Verdampferschiffchens (4) bilden.

2.  Verdampferschiffchen nach Anspruch 1, **dadurch gekennzeichnet**, daß die insgesamt sechs Ecken aufweisende Grundrißflächen-Konfiguration des Verdampferschiffchens (4) ein Breiten/Längenverhältnis (B' zu L') von etwa 1 : 4 aufweist, wobei sich die größte Breite (B') zur Breite (F) an der Einspannfläche (6, 6') wie etwa 1 : 1,3 verhält.

3.  Verdampferschiffchen nach den Ansprüchen 1 und 2, **dadurch gekennzeichnet**, daß die etwa rhomboidförmige, an zwei diametral gegenüberliegenden Enden abgeplattete Grundrißfläche des Verdampferschiffchens (4) ein Sechseck bildet, bei dem vier paarweise gegenüberliegende Ecken etwa gleichwinklig ausgebildet sind und bei dem das Verhältnis der größten Längenausdehnung (L) der Vertiefung (5) zu ihrer größten Breitenausdehnung (B) geringer bemessen ist als das Verhältnis der größten Länge (L') des ganzen Schiffchens (4) zu seiner größten Breite (B').

4.  Verdampferschiffchen nach den vorhergehenden Ansprüchen, **dadurch gekennzeichnet,** daß die beiden einander gegenüberliegenden Seitenflächen des Verdampferschiffchens im Bereich der größten Breite des im übrigen etwa rhomboidförmig konfigurierten Schiffchens beiderseits mit je einer weiteren Abplattung versehen sind, so daß die Grundrißfläche des Verdampferschiffchens insgesamt acht Ecken aufweist.

**Claims**

1.  Evaporator boat (4) for a substrate-coating apparatus in a vacuum coating chamber, consisting of a flat trough-shaped part of an electrically conductive material, wherein the boat can be heated by the direct passage of a current, characterized in that the evaporator boat (4) has a substantially rhombus-shaped or rhomboid-shaped horizontal projection, the configuration of the recess (5) corresponding roughly to that of the boat (4) and two diametrally opposed corners of the evaporator boat being provided with a respective roughly rectangular vertical flattened region which together form the mutually parallel fixing faces (6, 6') of the evaporator boat (4).

2.  Evaporator boat according to Claim 1, characterized in that the horizontal projection configuration of the vaporator boat (4) having a total of six corners has a width to length ratio (B' to L') of about 1 : 4, the maximum width (B') to the width (F) on the fixing face (6, 6') behaving roughly as 1 : 1.3.

3.  Evaporator boat according to Claims 1 and 2, characterized in that the roughly rhomboid-shaped horizontal projection of the evaporator boat (4) which is flattened at two diametrally opposed ends forms a hexagon in which four corners opposed in pairs are roughly equiangular and in which the ratio of the maximum length dimension (L) of the recess (5) to its maximum width dimension (B) is smaller than the ratio of the maximum length (L') of the entire boat (4) to its maximum width (B').

4.  Evaporator boat according to the preceding claims, characterized in that the two mutually opposed lateral faces of the evaporator boat are provided with a further flattened region on either side in each case in the region of the maximum width of the boat which is configured elsewhere roughly in the form of a rhomboid, so the horizontal projection of the evaporator boat has a total of eight corners.

**Revendications**

1. Nacelle d'évaporation (4) pour un dispositif de revêtement de substrats dans une chambre de revêtement sous vide, constituée d'une partie plate, en forme d'auge, en un matériau électriquement conducteur, la nacelle pouvant être chauffée par passage direct du courant, caractérisée par le fait que la nacelle d'évaporation (4) présente une surface de contour de base sensiblement en forme de losange ou de rhomboïde, la configuration de l'évidement (5) correspondant à peu près à celle de la nacelle (4) et deux sommets, diamétralement opposés l'un à l'autre, de la nacelle d'évaporation étant chacun munis d'un aplatissement rectangulaire, vertical, aplatissements qui forment ensemble des surfaces de bridage (6, 6'), parallèles l'une à l'autre, de la nacelle d'évaporation (4).

2. Nacelle d'évaporation selon la revendication 1, caractérisée par le fait que la configuration des surfaces de contour de base, présentant au total six sommets, de la nacelle d'évaporation (4) présente un rapport largeur/longueur (B' à L') d'environ 1:4, la plus grande largeur (B') étant, avec la largeur (F) sur la surface de bridage (6, 6'), dans le rapport d'à peu près 1 : 1, 3.

3. Nacelle d'évaporation selon la revendication 1 et 2, caractérisée par le fait que la surface de contour de base, à peu près en forme de losange, aplatie sur deux extrémités diamétralement opposées, de la nacelle d'évaporation (4) forme un hexagone dans le cas duquel quatre sommets, opposés l'un à l'autre par paire, forment à peu près un angle identique, et dans le cas duquel le rapport entre la plus grande extension en longueur (L) de l'évidement (5) et sa plus grande extension en largeur (B) est dimensionné inférieur au rapport entre la plus grande longueur (L') de la totalité de la nacelle (4') et sa plus grande largeur (B').

4. Nacelle d'évaporation selon les revendications précédentes, caractérisée par le fait que les deux surfaces latérales, opposées l'une à l'autre, de la nacelle d'évaporation sont munies, dans la zone de la plus grande largeur de la nacelle, par ailleurs à peu près configurée en forme de rhomboïde, sont, chacune, munies, des deux côtés, d'un autre aplatissement, de sorte que la surface de contour de base de la nacelle d'évaporation présente au total huit sommets.

# FIG.1

# FIG.2